# EUROPEAN PATENT SPECIFICATION

(11) **EP 4 185 081 B1**
(45) Date of publication and mention of the grant of the patent: **29.10.2025**
(21) Application number: 20947848.6
(22) Date of filing: 07.08.2020
(51) Int. Cl.: H05K 7/20, H04W 88/08

(54) **HEAT RADIATOR, METHOD FOR MANUFACTURING HEAT RADIATOR AND RADIO REMOTE UNIT**
WÄRMESTRAHLER, VERFAHREN ZUR HERSTELLUNG EINES WÄRMESTRAHLERS UND FERNFUNKEINHEIT
RADIATEUR THERMIQUE, PROCÉDÉ DE FABRICATION D'UN RADIATEUR THERMIQUE ET UNITÉ RADIO DISTANTE

(43) Date of publication of application: 24.05.2023
(73) Proprietor: Huawei Technologies Co., Ltd., Shenzhen, Guangdong 518129 (CN)
(72) Inventor: LI, Long, Shenzhen, Guangdong 518129 (CN); OHLSSON, Fredrik, Shenzhen, Guangdong 518129 (CN); TSOI, Vadim, Shenzhen, Guangdong 518129 (CN); CHEN, Fumin, Shenzhen, Guangdong 518129 (CN); ZHANG, Li, Shenzhen, Guangdong 518129 (CN); JIANG, Jin, Shenzhen, Guangdong 518129 (CN); DONG, Ying, Shenzhen, Guangdong 518129 (CN); YU, Haisheng, Shenzhen, Guangdong 518129 (CN)
(74) Representative: Epping - Hermann - Fischer
(86) International application number: PCT/CN2020/107745
(87) International publication number: WO 2022/027566

(56) References cited:
- EP-A1- 2 431 701
- CN-A- 103 717 036
- CN-A- 104 472 028
- CN-A- 105 627 810
- CN-U- 210 694 710
- CN-U- 210 694 710
- CN-Y- 2 627 649
- US-A1- 2015 371 571

## Description

### TECHNICAL FIELD

This application relates to the field of communication technologies, and in particular, to a radiator, a method for manufacturing a radiator, and a remote radio unit.

### BACKGROUND

A remote radio unit is located between a base station and a mobile terminal, and is connected to an upper-level base station by using an optical fiber. The remote radio unit is used to receive and transmit a radio frequency signal with the upper-level base station under the control of a base station controller. With continuous improvement of network performance, integration of the remote radio unit is constantly improved, and a requirement for a heat dissipation capability of the remote radio unit is also continuously improved.

Currently, in a conventional remote radio unit, a die-casting aluminum alloy radiator is usually used as a main heat dissipation means for heat dissipation. Specifically, the die-casting aluminum alloy radiator includes a substrate and a plurality of heat sink fins located on the substrate, and the heat sink fins are arranged on one side of the substrate in parallel at equal distances. A heat source component of the remote radio unit is in contact with the other side of the substrate, and both a forming material of the substrate and a forming material of the heat sink fins are die-casting aluminum alloys. Heat of a heat generation element is sequentially diffused onto the substrate and the heat sink fins, and heat is exchanged with an environment by using the substrate and the heat sink fins, to dissipate the heat.

However, in the foregoing radiator, the substrate in direct contact with a heat source is a die-casting aluminum alloy substrate, and is limited by a relatively low coefficient of thermal conductivity of a material of the substrate, and heat dissipation uniformity is relatively poor. Consequently, a heat dissipation effect of the radiator is poor.

Document CN210694710U discloses a remote radio unit heat dissipation device, which comprises a device main body, a heat dissipation plate, a liquid absorption core structure and a heating device.

### SUMMARY

This application provides a radiator, a method for manufacturing a radiator, and a remote radio unit, to effectively improve a heat dissipation effect of the radiator, and resolve a problem that a heat dissipation effect of an existing radiator is poor due to a relatively low coefficient of thermal conductivity of a material of a substrate that is in contact with a heat source.

According to a first aspect, this application provides a radiator used for heat dissipation of a remote radio unit, and includes a tank and a heat dissipation component disposed in the tank.

The heat dissipation component includes a housing, the housing has an accommodation cavity for accommodating cooling liquid, there is a first opening on one side of the tank, and the heat dissipation component is in contact with a heat source component of the remote radio unit by using the first opening.

In this way, the cooling liquid in the accommodation cavity vaporizes and evaporates into the accommodation cavity after absorbing heat dissipated from the heat source component. The vaporized and evaporated working liquid condenses and releases heat when touching an inner wall of the accommodation cavity (such as the top of the accommodation cavity) with relatively low temperature, and the condensed cooling liquid flows back to the bottom of the accommodation cavity. A cycle is repeated in this way, so that uniform heat dissipation is implemented. Compared with an existing die-casting aluminum alloy radiator, the heat dissipation component is in direct contact with a heat source, and gas-liquid two-phase heat dissipation can be formed in the heat dissipation component, so that relatively high temperature equalization performance is achieved. Therefore, a heat dissipation effect of the radiator is effectively improved.

In addition, compared with a die-casting aluminum heat sink fin used in the existing radiator, a gas-liquid two-phase heat dissipation manner formed in the heat dissipation component can significantly reduce heat resistance on a heat transfer path and improve the heat dissipation effect of the radiator.

According to an embodiment of the invention, there is further a second opening on a side that is of the tank and that is opposite to the first opening, and the heat dissipation component is disposed in the tank by using the second opening.

The second opening is used to place the heat dissipation component in the tank, and may also facilitate fastening the tank and the heat dissipation component.

In a possible implementation of the first aspect, a first end that is of the heat dissipation component and that is close to the first opening is fixedly connected to the tank, and there are/is a protrusion and/or a groove on an outer side wall that is of the first end and that is in contact with an inner wall of the tank.

The protrusion and/or the groove are/is disposed on the outer side wall that is of the first end and that is in contact with the inner wall of the tank, so that a contact area between the heat dissipation component and the tank can be increased, and therefore, strength of a connection between the heat dissipation component and the tank is increased, and fastness and stability of the radiator are improved.

In a possible implementation of the first aspect, the protrusion and/or the groove are/is located at an end that is of the heat dissipation component and that is close to the bottom of the tank, or the protrusion and/or the groove are/is located at an end that is of the heat dissipation component and that is away from the bottom of the tank.

When the protrusion and/or the groove are/is located at the end that is of the heat dissipation component and that is close to the bottom of the tank, a cross-section of a bottom plate of the heat dissipation component is in an inverted-T shape. When the protrusion and/or the groove are/is located at the end that is of the heat dissipation component and that is away from the bottom of the tank, the cross-section of the bottom plate is in a T shape. Similarly, disposing of the protrusion and/or the groove can improve fastness of the connection between the tank and the heat dissipation component, so that the cross-section of the bottom plate is in the T shape or the inverted-T shape. In addition to improving the fastness of the connection, complexity of the heat dissipation component is reduced, and forming of the heat dissipation component is facilitated. In addition, when the heat dissipation component and the tank are fixedly connected in a friction stir welding manner, the cross-section of the bottom plate is in the T shape or the inverted-T shape, so that disposing and operation of a stirring rod can be facilitated.

In a possible implementation of the first aspect, the heat dissipation component is fixedly disposed in the tank in a welding manner.

The welding manner includes at least one of friction stir welding, brazing, or laser welding.

Compared with a manner of fastening by using threads, fixedly disposing the heat dissipation component in the tank in the welding manner can improve integrity of the radiator and reduce a risk of air leakage of the heat dissipation component.

In a possible implementation of the first aspect, the radiator further includes a fastener, there are fastening holes cooperating with the fastener on the heat dissipation component and the tank, and the heat dissipation component is fixedly disposed in the tank through cooperation between the fastener and the fastening holes.

When the heat dissipation component and the tank are fastened in a manner in which the fastener cooperates with the fastening holes, a solution is simple, a process is mature, implementation is convenient, and costs are relatively low. In a possible implementation of the first aspect, the radiator further includes a sealing layer, and the sealing layer is located between an outer wall of the heat dissipation component and the inner wall of the tank.

When the heat dissipation component and the tank are fixedly connected in the manner in which the fastener cooperates with the fastening holes, because the fastening hole is disposed on the heat dissipation component, air-tightness of the heat dissipation component may be relatively poor. Therefore, if the sealing layer is disposed between the outer wall of the heat dissipation component and the inner wall of the tank, air-tightness of the connection between the heat dissipation component and the tank can be improved, and a risk of air leakage can be reduced.

In a possible implementation of the first aspect, the heat dissipation component is fixedly disposed in the tank in an in-mold hot mounting manner.

Specifically, the heat dissipation component may be disposed in the tank when the tank is formed by using a mold, and if the heat dissipation component is disposed in the tank when the tank is formed, a process can be simplified, and costs can be reduced.

In a possible implementation of the first aspect, the housing includes a bottom plate, a top plate, and a plurality of heat sink fins disposed between the bottom plate and the top plate, the bottom plate, the top plate, and the heat sink fins are all hollow structures, and the hollow structures of the bottom plate, the heat sink fins, and the top plate are connected to form the accommodation cavity.

Compared with an existing die-casting aluminum alloy plate, the housing of the heat dissipation component includes the bottom plate, the top plate, and the heat sink fins, the bottom plate may be in contact with the heat source component by using the first opening, the bottom plate, the top plate, and the heat sink fins are hollow structures and are connected to form the accommodation cavity, and the cooling liquid is injected into the accommodation cavity, so that a gas-liquid two-phase heat dissipation manner is formed in the housing, temperature equalization is relatively high, and heat dissipation efficiency is effectively improved. There may be the plurality of heat sink fins, and the plurality of heat sink fins may be arranged in parallel at equal distances. The plurality of heat sink fins may provide more accommodating space, and may further increase a contact area for evaporation or condensation, so that the heat dissipation effect is further improved.

According to a second aspect, this application provides a method for manufacturing a radiator, the radiator is used for heat dissipation of a remote radio unit, and the method includes:
forming a heat dissipation component, where the heat dissipation component includes a housing, and the housing includes an accommodation cavity used to accommodate cooling liquid; and
forming a tank and disposing the heat dissipation component in the tank, where the heat dissipation component is in contact with a heat source component of the remote radio unit by using a first opening on one side of the tank.

In the radiator formed by using the foregoing steps, the heat dissipation component is in contact with the heat source component, and the heat dissipation component includes the accommodation cavity used to accommodate the cooling liquid. The cooling liquid in the accommodation cavity vaporizes and evaporates into the accommodation cavity after absorbing heat dissipated from the heat source component. The vaporized and evaporated working liquid condenses and releases heat when touching an inner wall of the accommodation cavity (such as the top of the accommodation cavity) with relatively low temperature, and the condensed cooling liquid flows back to the bottom of the accommodation cavity. A cycle is repeated in this way, so that uniform heat dissipation is implemented. Relatively high temperature equalization performance is achieved, so that a heat dissipation effect of the radiator is effectively improved.

According to the second aspect, the forming a tank and disposing the heat dissipation component in the tank includes:
forming the tank; and
fixedly disposing the heat dissipation component in the tank in a welding manner.

In this way, the heat dissipation component is disposed in the tank in the welding manner. The welding manner can improve integrity of the radiator, and reduce a risk of air leakage of the heat dissipation component.

In a possible implementation of the second aspect, the fixedly disposing the heat dissipation component in the tank in a welding manner includes:
welding the heat dissipation component to the tank by using a friction stir welding process.

In a possible implementation of the second aspect, the fixedly disposing the heat dissipation component in the tank in a welding manner includes:
welding the heat dissipation component to the tank by using a laser welding process.

In a possible implementation of the second aspect, the fixedly disposing the heat dissipation component in the tank in a welding manner includes:
welding the heat dissipation component to the tank by using a brazing process.

In a possible implementation of the second aspect, the radiator further includes a fastener; and
after the forming a heat dissipation component, the method further includes: forming a fastening hole on the heat dissipation component; and
the forming a tank and disposing the heat dissipation component in the tank includes:
   forming the tank, and forming the fastening hole on the tank; and
   fixedly disposing the heat dissipation component in the tank through cooperation between the fastener and the fastening hole.

In this way, the tank and the heat dissipation component are fixedly connected through cooperation between the fastener and the fastening hole. This connection manner is easy to operate, a process is mature, and costs are relatively low.

In a possible implementation of the second aspect, after the fixedly disposing the heat dissipation component in the tank through cooperation between the fastener and the fastening hole, the method further includes:
forming a sealing layer between an outer wall of the heat dissipation component and an inner wall of the tank.

The sealing layer can improve air-tightness of the connection between the heat dissipation component and the tank, and reduce a risk of air leakage.

In a possible implementation of the second aspect, the forming a tank and disposing the heat dissipation component in the tank includes:
providing a die-casting mold of the tank; and
placing the heat dissipation component in the die-casting mold, and forming the tank in a hot mounting die-casting manner, where the heat dissipation component is located in the tank.

In this way, the heat dissipation component is disposed in the tank when the tank is formed in an in-mold hot mounting manner, so that an operation can be simplified, and costs can be reduced.

In a possible implementation of the second aspect, the forming a heat dissipation component includes:
forming the heat dissipation component by using a brazing process.

According to a third aspect, this application provides a radiator, and the radiator is obtained by using the foregoing method.

A heat dissipation component in the radiator obtained by using the foregoing method is in contact with a heat source component, and the heat sink component includes an accommodation cavity used to accommodate cooling liquid. The accommodation cavity may be in a gas-liquid two-phase heat dissipation manner, so that heat dissipation uniformity is effectively improved, and a heat dissipation effect of the radiator is further improved.

According to a fourth aspect, this application provides a remote radio unit, including at least a heat source component and the foregoing radiator, and a heat dissipation component in the radiator is in contact with the heat source component.

The heat source component and the radiator are included. The heat dissipation component of the radiator is in contact with the heat source component, and the heat dissipation component includes an accommodation cavity used to accommodate cooling liquid. The cooling liquid in the accommodation cavity vaporizes and evaporates into the accommodation cavity after absorbing heat dissipated from the heat source component. The vaporized and evaporated working liquid condenses and releases heat when touching an inner wall of the accommodation cavity (such as the top of the accommodation cavity) with relatively low temperature, and the condensed cooling liquid flows back to the bottom of the accommodation cavity. A cycle is repeated in this way, so that uniform heat dissipation is implemented, and relatively high temperature equalization performance and a relatively good heat dissipation effect are implemented. In this way, a heat dissipation capability of the remote radio unit is improved.

### BRIEF DESCRIPTION OF DRAWINGS

FIG. 1 is a schematic diagram of a partial split structure of a radiator according to an embodiment of this application;
FIG. 2 is a schematic cross-sectional diagram of contact between a radiator and a heat source component according to an embodiment of this application;
FIG. 3 is a schematic diagram of a structure of a heat dissipation component in a radiator according to an embodiment of this application;
FIG. 4 is a schematic cross-sectional diagram of a radiator according to an embodiment of this application;
FIG. 5 is a schematic cross-sectional diagram of another radiator according to an embodiment of this application;
FIG. 6 is a schematic cross-sectional diagram of still another radiator according to an embodiment of this application;
FIG. 7 is a schematic cross-sectional diagram of still another radiator according to an embodiment of this application;
FIG. 8 is a schematic diagram of a structure of a radiator formed through friction stir welding between a heat dissipation component and a tank according to an embodiment of this application;
FIG. 9 is a schematic diagram of a structure of a radiator formed by brazing a heat dissipation component and a tank according to an embodiment of this application;
FIG. 10 is a schematic diagram of a mechanism of a radiator formed between a heat dissipation component and a tank through cooperation between a fastener and a fastening hole according to an embodiment of this application; and
FIG. 11 is a flowchart of a method for manufacturing a radiator according to an embodiment of this application.

Descriptions of reference numerals
10-Radiator; 11-Tank; 111-First opening; 112-Second opening; 113-Die-casting layer; 12-Heat dissipation component; 121-Housing; 121a-Bottom plate; 121b-Top plate; 121c-Heat dissipation fin; 122-Accommodation cavity; 123-Protrusion; 124-Groove; 13 -Fastener; 20-Heat source component.

### DESCRIPTION OF EMBODIMENTS

Terms used in implementations of this application are only used to explain specific embodiments of this application, but are not intended to limit this application.

As a communication product such as a remote radio unit has an increasingly high integration degree and increasingly high power consumption, a requirement for heat dissipation efficiency of the product is also increasingly high. A conventional heat source component generally uses a die-casting aluminum alloy radiator as a main heat dissipation means. Specifically, the die-casting aluminum alloy radiator includes a substrate, and a plurality of heat sink fins are disposed in parallel on one side of the substrate, a heat emitting element of the remote radio unit is disposed on a board, and the other end that is of the substrate and that is opposite to the heat sink fins is in contact with the board, and heat emitted by a heat source is sequentially diffused from the board to the substrate and the heat sink fins. Heat dissipation is implemented through heat exchange between both the substrate and the heat sink fins and an environment.

However, because a coefficient of thermal conductivity of a die-casting aluminum alloy is relatively low, an effect of dissipating heat in a hot spot region from the substrate to the top of the heat sink fins (an end away from the substrate) is affected, and a relatively large temperature difference exists between the substrate part and the top of the heat sink fins. Consequently, heat dissipation uniformity is relatively poor, and a heat dissipation effect of the heat source component is reduced.

In a conventional technology, there is also a solution in which heat of a heat source component is dissipated by using a roll bonding cooler. Specifically, the roll bonding cooler is used instead of a die-casting fitting of the heat sink fin, so that the heat sink fin is formed by using the roll bonding cooler, and a good temperature equalization effect is achieved for heat dissipation between a root end (an end close to the substrate) and a top end of the heat sink fin by using the roll bonding cooler. In this way, a heat dissipation effect of the radiator is improved.

However, the substrate directly in direct contact with a heat source is a die-casting aluminum alloy, and the substrate is limited by a coefficient of thermal conductivity of a material of the substrate, and heat dissipation uniformity is relatively poor, and therefore the heat dissipation effect of the radiator needs to be further improved.

To resolve the foregoing technical problem, an embodiment of this application provides a radiator. A heat dissipation component is in contact with a heat source component of a remote radio unit, and the heat dissipation component includes an accommodation cavity used to accommodate cooling liquid. The cooling liquid can vaporize and evaporate after absorbing heat, and the vaporized cooling liquid can condense and release heat when touching an object with relatively low temperature. In this way, gas-liquid two-phase heat dissipation is formed in the heat dissipation component in direct contact with the heat source component, so that heat dissipation uniformity is effectively improved, temperature equalization performance of the radiator is improved, and a heat dissipation effect is improved. The radiator and a method for manufacturing the radiator are described below by using two embodiments.

### Embodiment 1

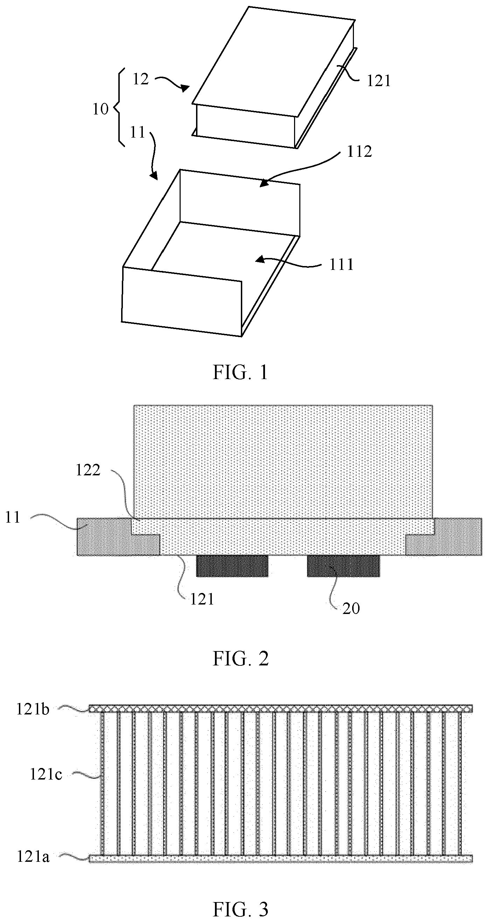

An embodiment of this application provides a radiator 10 used for heat dissipation of a remote radio unit. Specifically, the remote radio unit includes a heat source component, and the heat source component generates a large amount of heat during running, and is, for example, a PCB circuit board (printed circuit board, Printed Circuit Boards) with a radio frequency function. The radiator 10 mainly dissipates heat for the heat source component. As shown in FIG. 1, the radiator 10 includes a tank 11 and a heat dissipation component 12 disposed in the tank 11. Specifically, the tank 11 has an accommodation cavity used to accommodate the heat dissipation component 12, and the heat dissipation component 12 is disposed in the accommodation cavity. The heat dissipation component 12 and the tank 11 may be disposed in a manner such as welding, bonding, hot mounting, or a threaded connection.

The heat dissipation component 12 includes a housing 121, and the housing 121 includes an accommodation cavity 122 for accommodating cooling liquid. The cooling liquid can vaporize and evaporate after absorbing heat, and the vaporized cooling liquid can condense and release heat when touching an object with relatively low temperature. In this way, a gas-liquid two-phase heat dissipation manner can be formed in the heat dissipation component 12. There is a first opening 111 on one side of the tank 11, and the heat dissipation component 12 is in contact with a heat source component 20 by using the first opening 111. Specifically, one end of the heat dissipation component 12 may be embedded into the first opening 111, so that the radiator 10 is in contact with the heat source component 20 for heat exchange.

As shown in FIG. 2, the heat dissipation component 12 is in contact with the heat source component 20, so that a side that is of the accommodation cavity 122 and that is close to the heat source component 20 is the bottom of the accommodation cavity 122, and a side opposite to the bottom is the top of the accommodation cavity 122. After absorbing heat emitted by the heat source component 20, the cooling liquid in the accommodation cavity 122 vaporizes and evaporates into the accommodation cavity 122, and the evaporated and vaporized working liquid condenses and releases heat when touching an inner wall of the accommodation cavity 122 (such as the top of the accommodation cavity 122) with relatively low temperature, and the condensed cooling liquid flows back to the bottom of the accommodation cavity 122. A cycle is repeated in this way, so that uniform heat dissipation is implemented. Compared with an existing die-casting aluminum alloy radiator, the heat dissipation component 12 is in direct contact with a heat source, and gas-liquid two-phase heat dissipation can be formed in the heat dissipation component 12, so that relatively high temperature equalization performance is achieved. Therefore, a heat dissipation effect of the radiator 10 is effectively improved.

In addition, compared with a die-casting aluminum heat sink fin used in the existing radiator, a gas-liquid two-phase heat dissipation manner formed in the heat dissipation component 12 can significantly improve temperature equalization and heat dissipation performance of the radiator 10, and can also significantly reduce heat resistance on a heat transfer path, so that the heat dissipation effect of the radiator 10 is improved.

As shown in FIG. 1, there is further a second opening 112 on a side that is of the tank 11 and that is opposite to the first opening 111, the heat dissipation component 12 is disposed in the tank 11 by using the second opening 112, and the second opening 112 is used to place the heat dissipation component 12 in the tank 11, and can also facilitate fixed disposing of the tank 11 and the heat dissipation component 12.

A shape of the tank may be cuboid-shaped, as shown in FIG. 1. There is the first opening 111 connected to the accommodation cavity on a side surface of the tank 11, there is the second opening 112 on a side surface opposite to the first opening 111, and an opening can also be disposed on one or more side surfaces between the first opening 111 and the second opening 112, to increase contact between the heat dissipation component and an external environment, so that heat of the heat dissipation component can be better dissipated, and this helps improve the heat dissipation effect of the radiator.

The tank 11 may be formed by using a die-casting aluminum alloy material. It may be understood that the shape of the tank 11 may alternatively be another shape such as a cube or a circle. A forming material of the heat dissipation component 12 may be metal with a relatively high coefficient of thermal conductivity such as aluminum or copper, and an alloy material thereof.

Refer to FIG. 3. In a possible implementation, the housing 121 of the heat dissipation component 12 may include a bottom plate 121a, a top plate 121b, and a heat dissipation fin 121c located between the bottom plate 121a and the top plate 121b. The bottom plate 121a of the heat dissipation component 12 may be in contact with the heat source component 20 by using the first opening 111, and has a relatively large contact area, and this helps improve a heat dissipation effect.

The bottom plate 121a, the top plate 121b, and the heat dissipation fin 121c are all hollow structures, and the hollow structures of the bottom plate 121a, the heat dissipation fin 121c, and the top plate 121b are connected to form the accommodation cavity 122. Specifically, for example, the bottom plate 121a has a first cavity, the top plate 121b has a second cavity, the heat dissipation fin 121c has a third cavity, one end of the third cavity is connected to the first cavity, the other end of the third cavity is connected to the second cavity, and the connected first cavity, second cavity, and third cavity form the accommodation cavity 122. The cooling liquid is injected into the accommodation cavity 122.

There may be a plurality of heat sink fins 121c, and the plurality of heat sink fins 121c may be arranged in parallel at equal distances. The plurality of heat sink fins 121c may provide more accommodating space, and may further increase a contact area for evaporation or condensation, so that the heat dissipation effect is further improved.

In this embodiment of this application, a first end that is of the heat dissipation component 12 and that is close to the first opening 111 is fixedly connected to the tank 11. Specifically, in this embodiment of this application, the bottom plate 121a is the first end that is of the heat dissipation component 12 and that is close to the first opening 111; in other words, the bottom plate 121a is fixedly connected to the tank 11. There are/is a protrusion 123 and/or a groove 124 on an outer side wall that is of the first end and that is in contact with an inner wall of the tank 11. Specifically, as shown in FIG. 1, the tank 11 and the heat dissipation component 12 each may be cuboid-shaped. The tank 11 has an accommodation cavity, and the heat dissipation component 12 is disposed in the accommodation cavity. There is the first opening 111 on one side of the tank 11, and the bottom plate 121a of the heat dissipation component 12 is in contact with the heat source component 20 by using the first opening 111. There is the second opening 112 on the side that is of the tank 11 and that is opposite to the first opening 111, and the heat dissipation component 12 may be disposed in the tank 11 by using the second opening 112.

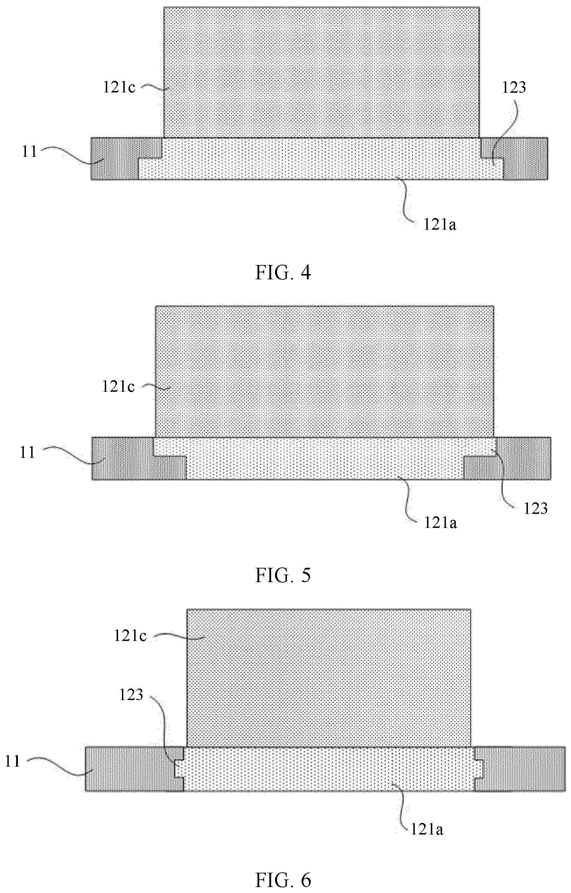

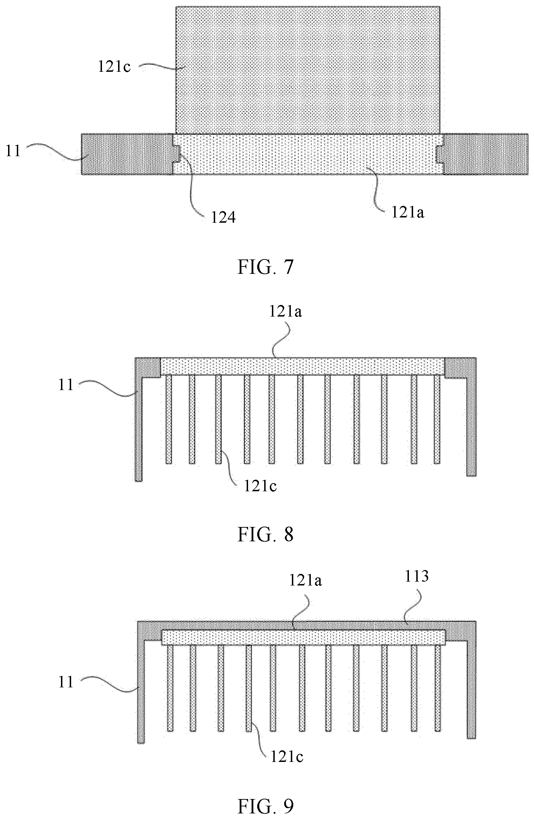

The bottom plate 121a is fixedly connected to the tank 11, and there are/is the protrusion 123 and/or the groove 124 on an outer side wall that is of the bottom plate 121a and that is in contact with the tank 11. Specifically, there may be the protrusion 123 on the outer side wall of the bottom plate 121a. As shown in FIG. 4, FIG. 5, and FIG. 6, there is a protrusion 123 formed outward on the outer side wall of the bottom plate 121a. Alternatively, there may be the groove 124 on the outer side wall of the bottom plate 121a. As shown in FIG. 7, there is a groove 124 formed inward on the outer side wall of the bottom plate 121a. Alternatively, there may be both the protrusion 123 and the groove 124 on the outer side wall of the bottom plate 121a.

One protrusion 123 and/or one groove 124 may be formed on the outer side wall. As shown in FIG. 6, there is one protrusion 123 on the outer side wall, so that a cross-section of the outer side wall of the bottom plate 121a is an arcuate structure. As shown in FIG. 7, there is one groove 124 on the outer side wall, so that a cross-section of the outer side wall of the bottom plate 121a is a serrated structure. Alternatively, a plurality of protrusions 123 and/or grooves 124 may be formed on the outer side wall, to further improve fastness of a connection between the tank 11 and the heat dissipation component 12.

In a possible implementation, the protrusion 123 and/or the groove 124 are located on an end that is of the heat dissipation component 12 and that is close to the bottom of the tank 11. Specifically, as shown in FIG. 4, the bottom of the tank 11 is an end that is of the tank 11 and that is close to the bottom of the accommodation cavity 122, and the top of the tank 11 is an end opposite to the bottom. The protrusion 123 is located on an end that is of a bottom wall of the heat dissipation component 12 and that is close to the bottom of the tank 11, so that a cross-section of the bottom plate 121a is in an inverted-T shape shown in FIG. 4.

Alternatively, the protrusion 123 and/or the groove 124 are/is located on an end that is of the heat dissipation component 12 and that is away from the bottom of the tank 11, as shown in FIG. 5, so that a cross-section of the bottom plate 121a is in a T shape shown in FIG. 5. Similarly, disposing of the protrusion 123 and/or the groove 124 can improve fastness of the connection between the tank 11 and the heat dissipation component 12, so that the cross-section of the bottom plate 121a is in the T shape or the inverted-T shape. In addition to improving the fastness of the connection, complexity of the heat dissipation component 12 is reduced, and forming of the heat dissipation component 12 is facilitated. In addition, when the heat dissipation component 12 and the tank 11 are fixedly connected in a friction stir welding manner, the cross-section of the bottom plate 121a is in the T shape or the inverted-T shape, so that disposing and operation of a stirring rod can be facilitated.

In a possible implementation, the heat dissipation component 12 may be fixedly disposed in the tank 11 in a welding manner. The welding manner may specifically include at least one of friction stir welding, brazing, or laser welding. Compared with a manner of fastening by using threads, fixedly disposing the heat dissipation component 12 in the tank 11 in the welding manner can improve integrity of the radiator 10 and reduce a risk of air leakage of the heat dissipation component 12.

Specifically, as shown in FIG. 8, the heat dissipation component 12 is fastened to the tank 11 in the friction stir welding manner. As shown in FIG. 8, the bottom plate 121a is welded to the tank 11, there is the first opening 111 on the tank 11, and the bottom plate 121a is embedded into the first opening 111, and may be in direct contact with the heat source component 20 by using the first opening 111.

It should be noted that, when the heat dissipation component 12 is fastened to the tank 11 in a brazing manner, as shown in FIG. 9, when the bottom plate 121a is connected to the tank 11 in the brazing manner, to facilitate a brazed connection between the tank 11 and the bottom plate 121a, a die-casting layer 113 may be covered at the first opening 111 of the tank 11, and the bottom plate 121a is welded to the die-casting layer 113 in the brazing manner. This is easy to implement. However, the heat dissipation component 12 is in contact with the heat source component 20 by using the die-casting layer 113 on the first opening 111, and thickness of the die-casting layer 113 is far less than thickness of the tank 11, so that a relatively small heat loss is caused. Compared with a manner such as friction stir welding, a heat dissipation effect is reduced. However, compared with an existing case in which a substrate is in contact with a heat source, the thickness of the die-casting layer 113 is relatively small, so that heat resistance on a heat transfer path can be reduced, and the heat dissipation effect can be improved.

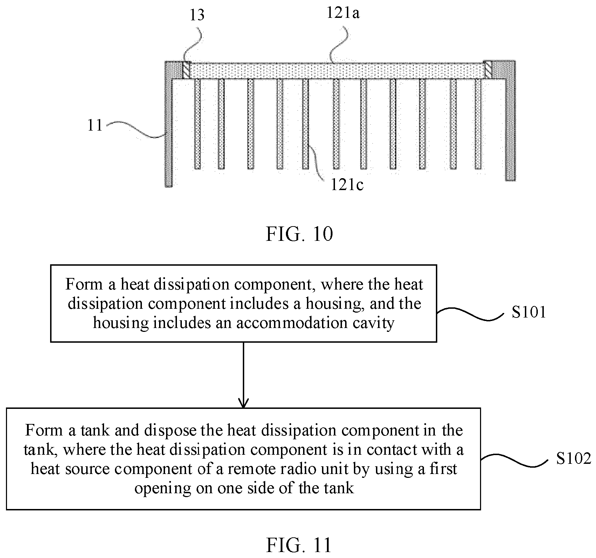

In another possible implementation, as shown in FIG. 10, the radiator 10 further includes a fastener 13, there are fastening holes (not shown in the figure) cooperating with the fastener 13 on the heat dissipation component 12 and the tank 11, and the heat dissipation component 12 is fixedly disposed in the tank 11 through cooperation between the fastener 13 and the fastening holes.

Specifically, for example, there may be a first fastening hole on the tank 11, and there is a second fastening hole on the bottom plate 121a of the heat dissipation component 12. The fastener 13 may be a mechanical part with threads on an outer wall such as a screw, the second fastening hole may be a hole with threads on an inner wall, and the fastener 13 passes through the first fastening hole on the tank 11 and cooperates with the second fastening hole on the heat dissipation component 12 through threads, so that the heat dissipation component 12 is fixedly disposed in the tank 11. When the heat dissipation component 12 and the tank 11 are fastened in a manner in which the fastener 13 cooperates with the fastening holes, a solution is simple, a process is mature, implementation is convenient, and costs are relatively low.

When the heat dissipation component 12 and the tank 11 are fixedly connected in the manner in which the fastener 13 cooperates with the fastening holes, because the fastening hole is disposed on the heat dissipation component 12, air-tightness of the heat dissipation component 12 may be relatively poor. Therefore, in this embodiment of this application, the radiator 10 may further include a sealing layer (not shown in the figure), and the sealing layer is located between an outer wall of the heat dissipation component 12 and the inner wall of the tank 11. Specifically, the sealing layer may be a resin layer. Disposing of the sealing layer can improve air-tightness of the connection between the heat dissipation component 12 and the tank 11, and reduce a risk of air leakage.

The sealing layer may be disposed only between the bottom plate 121a and the tank 11, or the sealing layer may be disposed at a position at which the heat dissipation component 12 is in contact with the tank 11, for example, between the top plate 121b of the heat dissipation component 12 and the tank 11.

In another possible implementation, the heat dissipation component 12 is fixedly disposed in the tank 11 in an in-mold hot mounting manner. Specifically, the heat dissipation component 12 may be disposed in the tank 11 when the tank 11 is formed by using a mold, and if the heat dissipation component 12 is disposed in the tank 11 when the tank 11 is formed, a process can be simplified, and costs can be reduced.

As shown in FIG. 8, the formed tank 11 has the first opening 111, and the bottom wall of the heat dissipation component 12 is embedded in the first opening 111, to come into contact with the heat source component 20 by using the first opening 111. It should be noted that the radiator 10 is fixedly connected to the tank 11 in an in-mold hot mounting manner, and the second opening 112 may still be disposed on the tank 11, so that it is convenient to inject the cooling liquid into the radiator 10.

### Embodiment 2

An embodiment of this application provides a method for manufacturing a radiator. The radiator is used for heat dissipation of a remote radio unit. As shown in FIG. 11, the method includes the following steps.

S101: Form a heat dissipation component, where the heat dissipation component includes a housing, and the housing includes an accommodation cavity.

The heat dissipation component may be formed by using a brazing process, and a molding material of the heat dissipation component may be metal with relatively good thermal conductivity such as aluminum or copper or an alloy thereof.

Cooling liquid may be liquid with high latent heat of vaporization, such as a simple substance such as water, methanol, or acetone, or mixed refrigerant liquid thereof.

It should be noted that, in S101, when the heat dissipation component is formed, a liquid injection port connected to the accommodation cavity needs to be reserved on the housing, to facilitate injection of the cooling liquid.

S102: Form a tank and dispose the heat dissipation component in the tank, where the heat dissipation component is in contact with a heat source component of the remote radio unit by using a first opening on one side of the tank.

The tank may be separately formed, and the cooling liquid may be injected into the heat dissipation component, and then the heat dissipation component is disposed in the tank. Alternatively, when the tank is formed, the heat dissipation component is disposed in the tank together, and then the cooling liquid is injected into the heat dissipation component. In the radiator formed by using the foregoing steps, the heat dissipation component is in contact with the heat source component, and the heat dissipation component includes the accommodation cavity used to accommodate the cooling liquid. The cooling liquid in the accommodation cavity vaporizes and evaporates into the accommodation cavity after absorbing heat dissipated from the heat source component. The vaporized and evaporated working liquid condenses and releases heat when touching an inner wall of the accommodation cavity (such as the top of the accommodation cavity) with relatively low temperature, and the condensed cooling liquid flows back to the bottom of the accommodation cavity. A cycle is repeated in this way, so that uniform heat dissipation is implemented. Relatively high temperature equalization performance is achieved, so that a heat dissipation effect of the radiator is effectively improved.

In a possible implementation, step S102 includes the following method:
forming the tank, that is, separately forming the tank in a mold die-casting manner;
fixedly disposing the heat dissipation component in the tank in a welding manner.

In this way, the heat dissipation component is disposed in the tank in the welding manner. Specifically, a bottom plate of the heat dissipation component may be welded to the tank. The welding manner can improve integrity of the radiator, and reduce a risk of air leakage of the heat dissipation component.

Specifically, the step of fixedly disposing the heat dissipation component in the tank in a welding manner may include:
welding the heat dissipation component to the tank by using a friction stir welding process.

Alternatively, the step of fixedly disposing the heat dissipation component in the tank in a welding manner may include:
welding the heat dissipation component to the tank by using a laser welding process.

Alternatively, the fixedly disposing the heat dissipation component in the tank in a welding manner includes:
welding the heat dissipation component to the tank by using a brazing process.

In another possible implementation, the radiator further includes a fastener. After the heat dissipation component is formed in step S101, the method may further include: forming a fastening hole (that is, a second fastening hole) on the heat dissipation component.

Step S102 may include:
forming the tank, and forming the fastening hole (that is, the first fastening hole) on the tank; and
fixedly disposing the heat dissipation component in the tank through cooperation between the fastener and the fastening hole.

Specifically, the fastener may pass through the first fastening hole on the tank and cooperate with the second fastening hole on the bottom plate of the heat dissipation component, to fixedly connect the tank and the heat dissipation component by using the fastener and the fastening holes. A connecting manner in which the fastener cooperates with the fastening holes is simple, a process is mature, and costs are relatively low.

To improve air-tightness of the heat dissipation component, after the step of fixedly disposing the heat dissipation component in the tank through cooperation between the fastener and the fastening hole, the method may further include:
forming a sealing layer between an outer wall of the heat dissipation component and an inner wall of the tank. The sealing layer may be formed by coating a sealing material between the outer wall of the heat dissipation component and the inner wall of the tank, for example, the sealing layer may be a resin layer. Alternatively, the sealing layer may be a mechanical part with a sealing function, such as a sealing strip, and the mechanical part is disposed between the outer wall of the heat dissipation component and the inner wall of the tank.

In another possible implementation, step S102 may include:
providing a die-casting mold of the tank; and
placing the heat dissipation component in the die-casting mold, and forming the tank in a hot mounting die-casting manner, where the heat dissipation component is located in the tank. In this way, the heat dissipation component is disposed in the tank when the tank is formed in an in-mold hot mounting manner, so that an operation can be simplified, and costs can be reduced.

An embodiment of this application further provides a remote radio unit, including at least a heat source component and either radiator in Embodiment 1 and Embodiment 2. A heat dissipation component in the radiator is in contact with the heat source component. The heat source component is a heat generation component in the remote radio unit, such as a PCB circuit board.

According to the remote radio unit provided in this embodiment of this application, the heat source component and the radiator are included, the heat dissipation component of the radiator is in contact with the heat source component, and the heat dissipation component includes an accommodation cavity used to accommodate cooling liquid. The cooling liquid in the accommodation cavity vaporizes and evaporates into the accommodation cavity after absorbing heat dissipated from the heat source component. The vaporized and evaporated working liquid condenses and releases heat when touching an inner wall of the accommodation cavity (such as the top of the accommodation cavity) with relatively low temperature, and the condensed cooling liquid flows back to the bottom of the accommodation cavity. A cycle is repeated in this way, so that uniform heat dissipation is implemented, and relatively high temperature equalization performance and a relatively good heat dissipation effect are implemented. In this way, a heat dissipation capability of the remote radio unit is improved.

In descriptions of embodiments of this application, it should be noted that, unless otherwise specified and limited, terms "mount", "connect", and "connection" should be understood in a broad sense. For example, the connection may be a fixed connection, a connection implemented by using an intermediate medium, or a connection between two elements or an interaction relationship between two elements. A person of ordinary skill in the art may understand a specific meaning of the foregoing term in embodiments of this application based on a specific situation.

In the specification, claims, and accompanying drawings of embodiments of this application, the terms "first", "second", "third", "fourth", and the like (if existent) are intended to distinguish between similar objects but do not necessarily indicate a specific order or sequence.

## Claims

1. A radiator (10), used for heat dissipation of a remote radio unit, and comprising a tank (11) and a heat dissipation component (12) disposed in the tank (11), wherein
the heat dissipation component (12) comprises a housing (121), the housing (121) has an accommodation cavity (122) for accommodating cooling liquid, there is a first opening (111) on one side of the tank (11), and the heat dissipation component (12) is in contact with a heat source component (20) of the remote radio unit by using the first opening (111), wherein there is further a second opening (112) on a side that is of the tank (11) and that is opposite to the first opening (111), and the heat dissipation component (12) is disposed in the tank (11) by using the second opening (112).

2. The radiator (10) according to claim 1, wherein a first end that is of the heat dissipation component (12) and that is close to the first opening (111) is fixedly connected to the tank (11), and there are/is a protrusion (123) and/or a groove (124) on an outer side wall that is of the first end and that is in contact with an inner wall of the tank (11).

3. The radiator (10) according to claim 2, wherein the protrusion (123) and/or the groove (124) are/is located at an end that is of the heat dissipation component (12) and that is close to the bottom of the tank (11), or the protrusion (123) and/or the groove (124) are/is located at an end that is of the heat dissipation component (12) and that is away from the bottom of the tank (11).

4. The radiator (10) according to any one of claims 1 to 3, wherein the heat dissipation component (12) is fixedly disposed in the tank (11) in a welding manner; and
the welding manner comprises at least one of friction stir welding, brazing, and laser welding.

5. The radiator (10) according to any one of claims 1 to 3, further comprising a fastener (13), wherein there are fastening holes cooperating with the fastener (13) on the heat dissipation component (12) and the tank (11), and the heat dissipation component (12) is fixedly disposed in the tank (11) through cooperation between the fastener (13) and the fastening holes.

6. The radiator (10) according to claim 5, further comprising a sealing layer, wherein the sealing layer is located between an outer wall of the heat dissipation component (12) and the inner wall of the tank (11).

7. The radiator (10) according to any one of claims 1 to 3, wherein the heat dissipation component (12) is fixedly disposed in the tank (11) in an in-mold hot mounting manner.

8. The radiator (10) according to any one of claims 1 to 7, wherein the housing (121) comprises a bottom plate (121a), a top plate (121b), and a plurality of heat sink fins (121c) disposed between the bottom plate (121a) and the top plate (121b), the bottom plate (121a), the top plate (121b), and the heat sink fins (121c) are all hollow structures, and the hollow structures of the bottom plate (121a), the heat sink fins (121c), and the top plate (121b) are connected to form the accommodation cavity (122).

9. A method for manufacturing a radiator (10), wherein the radiator (10) is used for heat dissipation of a remote radio unit, and the method comprises:
forming (S101) a heat dissipation component (12), wherein the heat dissipation component (12) comprises a housing (121), and the housing (121) comprises an accommodation cavity (122) used to accommodate cooling liquid; and
forming (S102) a tank (11) and disposing the heat dissipation component (12) in the tank (11), wherein the heat dissipation component (12) is in contact with a heat source component (20) of the remote radio unit by using a first opening (111) on one side of the tank (11), wherein the forming a tank (11) and disposing the heat dissipation component (12) in the tank (11) comprises:
forming the tank (11); and
fixedly disposing the heat dissipation component (12) in the tank (11) in a welding manner, by using a second opening opposite to the first opening.

10. The method for manufacturing a radiator (10) according to claim 9, wherein the fixedly disposing the heat dissipation component (12) in the tank (11) in a welding manner comprises:
welding the heat dissipation component (12) to the tank (11) by using a friction stir welding process.

11. The method for manufacturing a radiator (10) according to claim 9, wherein the fixedly disposing the heat dissipation component (12) in the tank (11) in a welding manner comprises:
Welding the heat dissipation component (12) to the tank (11) by using a laser welding process.

12. The method for manufacturing a radiator (10) according to claim 9, wherein the fixedly disposing the heat dissipation component (12) in the tank (11) in a welding manner comprises:
welding the heat dissipation component (12) to the tank (11) by using a brazing process.

13. A radio remote unit, comprising at least a heat source component (20) and the foregoing radiator (10) according to any one of claims 1 to 8, wherein a heat dissipation component (12) in the radiator (10) is in contact with the heat source component (20).

## Patentansprüche

1. Radiator (10), der für eine Wärmeableitung einer entfernten Funkeinheit verwendet wird und einen Behälter (11) und eine Wärmeableitungskomponente (12), die in dem Behälter (11) eingerichtet ist, umfasst, wobei
die Wärmeableitungskomponente (12) ein Gehäuse (121) umfasst, das Gehäuse (121) einen Aufnahmehohlraum (122) zum Aufnehmen von Kühlflüssigkeit aufweist, eine erste Öffnung (111) an einer Seite des Behälters (11) vorhanden ist und die Wärmeableitungskomponente (12) durch Verwenden der ersten Öffnung (111) mit einer Wärmequellenkomponente (20) der entfernten Funkeinheit in Kontakt steht, wobei ferner eine zweite Öffnung (112) an einer Seite, die zu dem Behälter (11) gehört und die der ersten Öffnung (111) gegenüberliegt, vorhanden ist und die Wärmeableitungskomponente (12) durch Verwenden der zweiten Öffnung (112) in dem Behälter (11) eingerichtet ist.

2. Radiator (10) nach Anspruch 1, wobei ein erstes Ende, das zu der Wärmeableitungskomponente (12) gehört und das sich nahe der ersten Öffnung (111) befindet, mit dem Behälter (11) fest verbunden ist, und ein Vorsprung (123) und/oder eine Rille (124) an einer Außenseitenwand, die zu dem ersten Ende gehört und die mit einer Innenwand des Behälters (11) in Kontakt steht, vorhanden ist/sind.

3. Radiator (10) nach Anspruch 2, wobei der Vorsprung (123) und/oder die Rille (124) an einem Ende, das zu der Wärmeableitungskomponente (12) gehört und das sich nahe dem Boden des Behälters (11) befindet, gelegen ist/sind oder der Vorsprung (123) und/oder die Rille (124) an einem Ende, das zu der Wärmeableitungskomponente (12) gehört und das sich abseits von dem Boden des Behälters (11) befindet, gelegen ist/sind.

4. Radiator (10) nach einem der Ansprüche 1 bis 3, wobei die Wärmeableitungskomponente (12) mit einer Schweißmethode in dem Behälter (11) fest eingerichtet ist; und
die Schweißmethode mindestens eines von einem Reibrührschweißen, Hartlöten und Laserschweißen umfasst.

5. Radiator (10) nach einem der Ansprüche 1 bis 3, der ferner ein Befestigungselement (13) umfasst, wobei Befestigungslöcher, die mit dem Befestigungselement (13) zusammenwirken, an der Wärmeableitungskomponente (12) und dem Behälter (11) vorhanden sind und die Wärmeableitungskomponente (12) über ein Zusammenwirken zwischen dem Befestigungselement (13) und den Befestigungslöchern in dem Behälter (11) fest eingerichtet ist.

6. Radiator (10) nach Anspruch 5, der ferner eine Dichtungsschicht umfasst, wobei die Dichtungsschicht zwischen einer Außenwand der Wärmeableitungskomponente (12) und der Innenwand des Behälters (11) gelegen ist.

7. Radiator (10) nach einem der Ansprüche 1 bis 3, wobei die
Wärmeableitungskomponente (12) mit einer In-Mold-Warmmontagemethode in dem Behälter (11) fest eingerichtet ist.

8. Radiator (10) nach einem der Ansprüche 1 bis 7, wobei das Gehäuse (121) eine Bodenplatte (121a), eine Deckplatte (121b) und eine Vielzahl von Wärmesenkenrippen (121c), die zwischen der Bodenplatte (121a) und der Deckplatte (121b) eingerichtet sind, umfasst, wobei die Bodenplatte (121a), die Deckplatte (121b) und die Wärmesenkenrippen (121c) alle hohle Strukturen sind und die hohlen Strukturen der Bodenplatte (121a), der Wärmesenkenrippen (121c) und der Deckplatte (121b) verbunden sind, um den Aufnahmehohlraum (122) auszubilden.

9. Verfahren zum Herstellen eines Radiators (10), wobei der Radiator (10) für die Wärmeableitung einer entfernten Funkeinheit verwendet wird und das Verfahren umfasst:
Ausbilden (S101) einer Wärmeableitungskomponente (12), wobei die Wärmeableitungskomponente (12) ein Gehäuse (121) umfasst und das Gehäuse (121) einen Aufnahmehohlraum (122), der verwendet wird, um die Kühlflüssigkeit aufzunehmen, umfasst; und
Ausbilden (S102) eines Behälters (11) und Einrichten der Wärmeableitungskomponente (12) in dem Behälter (11), wobei die Wärmeableitungskomponente (12) durch Verwenden einer ersten Öffnung (111) an einer Seite des Behälters (11) mit einer Wärmequellenkomponente (20) der entfernten Funkeinheit in Kontakt steht, wobei das Ausbilden eines Behälters (11) und das Einrichten der Wärmeableitungskomponente (12) in dem Behälter (11) umfasst:
Ausbilden des Behälters (11); und
festes Einrichten der Wärmeableitungskomponente (12) in dem Behälter (11) mit einer Schweißmethode durch Verwenden einer zweiten Öffnung gegenüberliegend der ersten Öffnung.

10. Verfahren zum Herstellen eines Radiators (10) nach Anspruch 9, wobei das feste Einrichten der Wärmeableitungskomponente (12) in dem Behälter (11) mit einer Schweißmethode umfasst:
Verschweißen der Wärmeableitungskomponente (12) mit dem Behälter (11) durch Verwenden eines Reibrührschweißprozesses.

11. Verfahren zum Herstellen eines Radiators (10) nach Anspruch 9, wobei das feste Einrichten der Wärmeableitungskomponente (12) in dem Behälter (11) mit einer Schweißmethode umfasst:
Verschweißen der Wärmeableitungskomponente (12) mit dem Behälter (11) durch Verwenden eines Laserschweißprozesses.

12. Verfahren zum Herstellen eines Radiators (10) nach Anspruch 9, wobei das feste Einrichten der Wärmeableitungskomponente (12) in dem Behälter (11) mit einer Schweißmethode umfasst:
Verschweißen der Wärmeableitungskomponente (12) mit dem Behälter (11) durch Verwenden eines Lötprozesses.

13. Funkferneinheit, die mindestens eine Wärmequellenkomponente (20) und den vorgenannten Radiator (10) nach einem der Ansprüche 1 bis 8 umfasst, wobei eine Wärmeableitungskomponente (12) in dem Radiator (10) mit der Wärmequellenkomponente (20) in Kontakt steht.

## Revendications

1. Radiateur (10), utilisé pour une dissipation de chaleur d'une unité radio à distance, et comprenant un réservoir (11) et un composant de dissipation de chaleur (12) disposé dans le réservoir (11), dans lequel
le composant de dissipation de chaleur (12) comprend un boîtier (121), le boîtier (121) a une cavité de logement (122) pour loger un liquide de refroidissement, il existe une première ouverture (111) sur un côté du réservoir (11), et le composant de dissipation de chaleur (12) est en contact avec un composant de source de chaleur (20) de l'unité radio à distance en utilisant la première ouverture (111), dans lequel il existe en outre une seconde ouverture (112) sur un côté du réservoir (11) qui est opposée à la première ouverture (111), et le composant de dissipation de chaleur (12) est disposé dans le réservoir (11) en utilisant la seconde ouverture (112).

2. Radiateur (10) selon la revendication 1, dans lequel une première extrémité du composant de dissipation de chaleur (12) et qui est proche de la première ouverture (111) est reliée de manière fixe au réservoir (11), et il existe une saillie (123) et/ou une rainure (124) sur une paroi latérale extérieure de la première extrémité et qui est en contact avec une paroi intérieure du réservoir (11).

3. Radiateur (10) selon la revendication 2, dans lequel la saillie (123) et/ou la rainure (124) est/sont située(s) au niveau d'une extrémité du composant de dissipation de chaleur (12) et qui est proche du fond du réservoir (11), ou la saillie (123) et/ou la rainure (124) est/sont située(s) au niveau d'une extrémité du composant de dissipation de chaleur (12) et qui est éloignée du fond du réservoir (11).

4. Radiateur (10) selon l'une quelconque des revendications 1 à 3, dans lequel le composant de dissipation de chaleur (12) est disposé de manière fixe dans le réservoir (11) selon une méthode de soudage ; et
la méthode de soudage comprend au moins l'un parmi le soudage par friction-malaxage, le brasage et le soudage au laser.

5. Radiateur (10) selon l'une quelconque des revendications 1 à 3, comprenant en outre une attache (13), dans lequel il existe des trous d'attache coopèrent avec l'attache (13) sur le composant de dissipation de chaleur (12) et le réservoir (11), et le composant de dissipation de chaleur (12) est disposé de manière fixe dans le réservoir (11) par le biais d'une coopération entre l'attache (13) et les trous d'attache.

6. Radiateur (10) selon la revendication 5, comprenant en outre une couche d'étanchéité, dans lequel la couche d'étanchéité est située entre une paroi extérieure du composant de dissipation de chaleur (12) et la paroi intérieure du réservoir (11).

7. Radiateur (10) selon l'une quelconque des revendications 1 à 3, dans lequel le composant de dissipation de chaleur (12) est disposé de manière fixe dans le réservoir (11) selon une méthode de montage à chaud dans le moule.

8. Radiateur (10) selon l'une quelconque des revendications 1 à 7, dans lequel le boîtier (121) comprend une plaque inférieure (121a), une plaque supérieure (121b), et une pluralité d'ailettes de dissipation thermique (121c) disposées entre la plaque inférieure (121a) et la plaque supérieure (121b), la plaque inférieure (121a), la plaque supérieure (121b) et les ailettes de dissipation thermique (121c) sont toutes des structures creuses, et les structures creuses de la plaque inférieure (121a), des ailettes de dissipation thermique (121c) et de la plaque supérieure (121b) sont reliées pour former la cavité de logement (122).

9. Procédé permettant de fabriquer un radiateur (10), dans lequel le radiateur (10) est utilisé pour une dissipation de chaleur d'une unité radio à distance, et le procédé comprend :
la formation (S101) d'un composant de dissipation de chaleur (12), dans lequel le composant de dissipation de chaleur (12) comprend un boîtier (121), et le boîtier (121) comprend une cavité de logement (122) utilisée pour loger un liquide de refroidissement ; et
la formation (S102) d'un réservoir (11) et la disposition du composant de dissipation de chaleur (12) dans le réservoir (11), dans lequel le composant de dissipation de chaleur (12) est en contact avec un composant de source de chaleur (20) de l'unité radio à distance en utilisant une première ouverture (111) sur un côté du réservoir (11), dans lequel la formation d'un réservoir (11) et la disposition du composant de dissipation de chaleur (12) dans le réservoir (11) comprennent :
la formation du réservoir (11) ; et
la disposition fixe du composant de dissipation de chaleur (12) dans le réservoir (11) selon une méthode de soudage, en utilisant une seconde ouverture opposée à la première ouverture.

10. Procédé permettant de fabriquer un radiateur (10) selon la revendication 9, dans lequel la disposition fixe du composant de dissipation de chaleur (12) dans le réservoir (11) selon la méthode de soudage comprend :
le soudage du composant de dissipation de chaleur (12) au réservoir (11) en utilisant un processus de soudage par friction-malaxage.

11. Procédé permettant de fabriquer un radiateur (10) selon la revendication 9, dans lequel la disposition fixe du composant de dissipation de chaleur (12) dans le réservoir (11) selon la méthode de soudage comprend :
le soudage du composant de dissipation de chaleur (12) au réservoir (11) en utilisant un processus de soudage au laser.

12. Procédé permettant de fabriquer un radiateur (10) selon la revendication 9, dans lequel la disposition fixe du composant de dissipation de chaleur (12) dans le réservoir (11) selon la méthode de soudage comprend :
le soudage du composant de dissipation de chaleur (12) au réservoir (11) en utilisant un processus de brasage.

13. Unité radio à distance, comprenant au moins un composant de source de chaleur (20) et le radiateur (10) susmentionné selon l'une quelconque des revendications 1 à 8, dans laquelle un composant de dissipation de chaleur (12) dans le radiateur (10) est en contact avec le composant de source de chaleur (20).
